(19) **Europäisches Patentamt / European Patent Office / Office européen des brevets**

(11) **EP 1 750 894 B1**

(12) **EUROPÄISCHE PATENTSCHRIFT**

(45) Veröffentlichungstag und Bekanntmachung des Hinweises auf die Patenterteilung:
**15.04.2009 Patentblatt 2009/16**

(21) Anmeldenummer: 05740372.7

(22) Anmeldetag: **19.05.2005**

(51) Int Cl.:
**B23K 26/14** *(2006.01)* **H01L 21/00** *(2006.01)*

(86) Internationale Anmeldenummer:
**PCT/CH2005/000284**

(87) Internationale Veröffentlichungsnummer:
**WO 2005/110662 (24.11.2005 Gazette 2005/47)**

(54) **LASERBEARBEITUNG EINES WERKSTÜCKS**

LASER MACHINING OF A WORKPIECE

USINAGE D'UNE PIECE AU LASER

(84) Benannte Vertragsstaaten:
**AT BE BG CH CY CZ DE DK EE ES FI FR GB GR HU IE IS IT LI LT LU MC NL PL PT RO SE SI SK TR**

(30) Priorität: **19.05.2004 EP 04405312**

(43) Veröffentlichungstag der Anmeldung:
**14.02.2007 Patentblatt 2007/07**

(73) Patentinhaber: SYNOVA S.A.
**1024 Ecublens (CH)**

(72) Erfinder:
• **RICHERZHAGEN, Bernold**
**CH-1025 St-Sulpice (CH)**

• **SPIEGEL, Akos**
**CH-1022 Chavannes (CH)**

(74) Vertreter: **Rüfenacht, Philipp Michael et al**
**Keller & Partner**
**Patentanwälte AG**
**Schmiedenplatz 5**
**Postfach**
**3000 Bern 7 (CH)**

(56) Entgegenhaltungen:
**WO-A-95/32834 DE-A- 4 138 468**
**US-A1- 2001 004 480 US-A1- 2003 062 126**

EP 1 750 894 B1

**Beschreibung**

Die Erfindung betrifft ein Verfahren zur Bearbeitung eines Werkstücks mit einer in einem Flüssigkeitsstrahl eingekoppelten und geführten Laserstrahlung, bei welchem der Flüssigkeitsstrahl mit der Laserstrahlung auf eine Oberfläche des Werkstücks gerichtet und das Werkstück in einem Arbeitspunkt bearbeitet wird. Weiter betrifft die Erfindung eine Vorrichtung zur Bearbeitung eines Werkstücks mit einer Laserstrahlung, welche auf eine Oberfläche des Werkstücks richtbar ist, wobei das Werkstück in einem Arbeitspunkt bearbeitbar und die Laserstrahlung in einem Flüssigkeitsstrahl eingekoppelt und geführt ist.

Laserstrahlung lässt sich, insbesondere in der Industrie, in vielfältiger Weise zur Bearbeitung verschiedenster Materialien wie beispielsweise Metalle, Kunststoffe oder auch Keramiken verwenden. Die Bearbeitung reicht von Schneiden, Bohren, Schweissen bis hin zu Materialabtragung oder Markieren.

Bei der Bearbeitung eines Werkstücks mit Laserstrahlung wird typischerweise Material des Werkstücks abgetragen. Dabei entstehen kleine Materialpartikel, der sogenannte Auswurf, welche sich wieder auf der Oberfläche des Werkstücks absetzen bzw. anschmelzen. Je nach Beschaffenheit des Werkstücks und/oder der Werkstückoberfläche bzw. des Auswurfs, kommt es vor, dass sich diese wieder fest miteinander verbinden. Diese Ablagerungen auf der Oberfläche des Werkstücks können die Eigenschaften des Endproduktes ungünstig beeinflussen und sind daher in der Regel unerwünscht. Sie müssen daher, falls dies überhaupt möglich ist, mit grossem Aufwand nachträglich wieder entfernt werden. Weiter wird das Werkstück bei der Bearbeitung mit Laserstrahlung typischerweise erwärmt, was ebenfalls unerwünschte Folgen für das Werkstück mit sich bringen kann.

Aus der WO/9532834 ist eine Vorrichtung bekannt, bei welcher die Laserstrahlung in einen Flüssigkeitsstrahl, der als Lichtleiter wirkt, eingekoppelt wird. Dadurch kann nicht nur die Energie der Laserstrahlung zum Arbeitspunkt gebracht werden, die Flüssigkeit wirkt zugleich auch als Kühlmittel, welches das Werkstück im Bearbeitungsbereich effizient kühlt. Weiter können Dämpfe, Partikel und Aerosole, die bei der Bearbeitung mit der Laserstrahlung entstehen, gebunden bzw. verhindert werden. Allerdings reicht die Flüssigkeitsmenge des Flüssigkeitsstrahls, in welchen die Laserstrahlung eingekoppelt ist, nicht aus, um den bei der Bearbeitung entstehenden Auswurf vollkommen wegzuspülen.

Aus der US 3 991 296 A ist eine weitere Vorrichtung zum Bearbeiten und Segmentieren eines Wafers mittels eines Lasers bekannt. Um das Festsetzen von Bearbeitungsrückständen auf dem Wafer zu verhindern, wird mit Hilfe einer durchsichtigen Glasplatte knapp oberhalb des Wafers ein geschlossener Zwischenraum erzeugt, der von deionisiertem Wasser durchströmt wird. Der auf den Wafer gerichtete Laserstrahl durchdringt die Glasplatte sowie die Wasserschicht und zerschneidet dann den Wafer, wobei das Wasser die dabei entstehenden Rückstände kühlen und so das Festsetzen der Rückstände auf dem Wafer verhindern soll. Nach dem Schneiden sollen diese Rückstände dann einfach weggewaschen werden, allenfalls unter Zuhilfenahme von schwachem Ultraschall.

Die Nachteile dieser Vorrichtung liegen darin, dass die Wasserschicht auf dem Wafer die Laserstrahlung derart stört (Brechung, Streuung, Dämpfung), dass der Laserstrahl sowohl an Schärfe als auch an Energie verliert, sodass das Werkstück nicht bzw. nicht mehr effizient bearbeitet werden kann. Zudem ist es bei dem beschriebenen Verfahren schwierig oder gar unmöglich, die beim Bearbeiten entstehende Schmelze aus dem Bearbeitungsbereich auszubringen, da die Glasplatte die Verwendung eines Schneidgases verhindert. Und schliesslich ist trotz der Wasserschicht eine nachträgliche Reinigung des Endproduktes notwendig.

In der US 2003/129 814 A1 ist ein weiteres Verfahren zur Bearbeitung eines Halbleiterelementes mit einem Laserstrahl beschrieben. Um die Streuung des Laserlichtes an den Rückständen zu vermeiden, wird das Siliziumsubstrat nach einer Seite gekippt und mit Wasser überspült. Dadurch werden die Rückstände um den Arbeitspunkt herum weggespült und gleichzeitig erfolgt eine Kühlung des Substrats.

Auch bei diesem Verfahren wird der Laserstrahl durch die Wasserschicht gestreut und gedämpft, was die Bearbeitung des Siliziumsubstrats erschwert oder gar verunmöglicht. Weiter ist es auch hier nicht möglich, die Schmelze aus dem Bearbeitungsbereich auf dem Siliziumsubstrat auszubringen, da kein Schneidgas verwendet werden kann, welches die Schmelze austreibt.

**Darstellung der Erfindung**

Aufgabe der Erfindung ist es, ein dem eingangs genannten technischen Gebiet zugehörendes Verfahren zu schaffen, welches die genannten Nachteile der bekannten Verfahren vermeidet und es insbesondere ermöglicht, ein Werkstrück effizient mit einer Laserstrahlung zu bearbeiten sowie die Ablagerung des bei der Bearbeitung entstehenden Auswurfs auf der Werkstückoberfläche weitgehend zu verhindern.

Die Lösung der Aufgabe ist durch die Merkmale des Anspruchs 1 definiert. Bei einem Verfahren zur Bearbeitung eines Werkstücks mit einer in einem Flüssigkeitsstrahl eingekoppelten und geführten Laserstrahlung, bei welchem der Flüssigkeitsstrahl mit der Laserstrahlung auf die Werkstückoberfläche gerichtet und das Werkstück in einem Arbeitspunkt bearbeitet wird, wird gemäss der Erfindung auf der Oberfläche des Werkstücks mit einer Flüssigkeit, beispielsweise Wasser, eine fliessende Flüssigkeitsschicht derart erzeugt, dass die Flüssigkeitsschicht in einem Arbeitsbereich um den Arbeitspunkt herum eine Dicke unter 1 Millimeter (mm), insbesondere zwischen 0.01 mm und 0.5 mm aufweist.

Dadurch, dass die Laserstrahlung in einen Flüssigkeitsstrahl eingekoppelt ist, der für die Laserstrahlung als Strahlleiter dient, wird es überhaupt erst möglich, mit der Laserstrahlung die dünne Flüssigkeitsschicht auf der Werkstückoberfläche ungestört zu durchdringen. Wie aus der WO/9532834 bekannt, weist der Flüssigkeitsstrahl eine hohe Geschwindigkeit auf. Dadurch wird die den Flüssigkeitsstrahl umgebende Luft an der Oberfläche des Strahls von diesem mitgerissen. Beim Auftreffen des Flüssigkeitsstrahls auf die dünne Flüssigkeitsschicht auf der Oberfläche des Werkstücks verdrängt dann der Strahl zusammen mit der mitgerissenen Luft die Flüssigkeitsschicht im Arbeitspunkt und leitet auf diese Weise die Laserstrahlung bis auf die Oberfläche des Werkstücks. Dadurch bleibt die Laserstrahlung scharf und wird durch die dünne Flüssigkeitsschicht weder gebrochen, noch gestreut oder gedämpft und das Werkstück kann effizient bearbeitet werden. Übersteigt die Dicke dieser Flüssigkeitsschicht den angegebenen Wert von maximal 1 mm, ist es trotz des Flüssigkeitsstrahls schwierig, die Flüssigkeitsschicht mit der Laserstrahlung ungestört zu durchdringen. Eine effiziente und präzise Bearbeitung des Werkstücks ist dann nicht mehr möglich. Rund um den Arbeitspunkt herum bewirkt die Flüssigkeitsschicht auf der Werkstückoberfläche, dass sich der Auswurf, welcher bei der Bearbeitung des Werkstücks mit der Laserstrahlung entsteht, abkühlt und sich nicht auf der Werkstückoberfläche ablagern kann. Die Flüssigkeitsschicht spült den abgekühlten Auswurf gleich weg. Weiter treibt der Flüssigkeitsstrahl die beim Bearbeiten entstehende Schmelze effizient aus dem Bearbeitungsbereich aus, womit die Verwendung eines Schneidgases unnötig wird. Gleichzeitig kann auf diese Weise eine noch bessere Kühlung des Werkstücks im Arbeitspunkt und insbesondere der Schnittkanten erreicht werden. Bei geeigneter Ausbildung des Flüssigkeitsstrahls können auf diese Weise lange, kompakte Laserstrahllängen bis zu Hundert Millimetern erreicht werden. Diese Technik ermöglicht auch schmale, tiefe Schnitte und Bohrungen mit praktisch senkrechten Seitenwänden ohne eine Nachführung des Fokuspunktes der Laserstrahlung. Auch Dämpfe und Gerüche können noch besser gebunden werden.

Bei einer nur langsam fliessenden oder gar ruhenden Flüssigkeitsschicht auf der Werkstückoberfläche wäre nicht gewährleistet, dass der Auswurf genügend gekühlt und vollständig weggespült würde. Zudem wäre die Dicke der Flüssigkeitsschicht im gewünschten Bereich unter 1 mm nur schwierig zu kontrollieren. Die Flüssigkeitsschicht auf der Werkstückoberfläche wird daher vorzugsweise derart erzeugt, dass sie im Arbeitsbereich schiessend fliesst. Dadurch wird es möglich, eine stabile, dünne Flüssigkeitsschicht mit einer Dicke von unter 1 mm zu erreichen. Zudem kann die Dicke der Flüssigkeitsschicht besser kontrolliert werden und durch die hohe und stabile Fliessgeschwindigkeit wird der Auswurf effizient gekühlt und weggespült, was eine saubere Werkstückoberfläche zur Folge hat und ein nachträgliches Reinigen überflüssig macht.

Der Begriff schiessend ist in der Hydrodynamik für Flüssigkeiten wohldefiniert. Er hängt mit der Froude-Zahl FR zusammen, welche bei einer fliessenden (flachen) Flüssigkeit definiert ist als Verhältnis der Fliessgeschwindigkeit v der Flüssigkeit zur Fortpflanzungsgeschwindigkeit (Wellengeschwindigkeit) c von Schwerewellen, d.h. Oberflächenwellen auf der Flüssigkeitsoberfläche: FR = v/c. Die Wellengeschwindigkeit c ihrerseits kann ausgedrückt werden als die Wurzel aus dem Produkt der Erdbeschleunigung g und der Flüssigkeitshöhe

$$c = \sqrt{g * h}.$$ Die Froude-Zahl ergibt sich somit zu

$$FR = v / \sqrt{g * h}.$$ D.h. eine

Flüssigkeit bewegt sich schiessend, wenn die Froude-Zahl grösser als 1 ist. Liegt die Froude-Zahl zwischen 0 und 1 fliesst die Flüssigkeit strömend. Bei einem stehenden Gewässer ist die Froude-Zahl folglich gleich 0.

Bei der Erzeugung der Flüssigkeitsschicht müssen jedoch folgende Bedingungen beachtet werden. Einerseits darf die Dicke der Flüssigkeitsschicht im Arbeitspunkt wie bereits erwähnt nicht zu gross sein, da sonst nämlich der Flüssigkeitsstrahl, in welchem die Laserstrahlung eingekoppelt ist, auf dem Weg durch die Flüssigkeitsschicht gestört und die Laserstrahlung aus dem Flüssigkeitsstrahl ausgekoppelt und somit zu stark gestreut wird.

Andererseits darf die Dicke der Flüssigkeitsschicht auch nicht zu klein werden, damit kein Bereich der Werkstückoberfläche austrocknet und damit keine geschmolzenen Materialpartikel oder Partikel mit geschmolzener Umhüllung die Flüssigkeitsschicht durchschlagen.

Je nach der konkreten Anwendung kann es sein, dass sich die obigen Anforderungen an die Flüssigkeitsschicht einander gegenseitig ausschliessen. Bei einer im Wesentlichen überall gleich dicken Flüssigkeitsschicht, kann es nämlich sein, dass die maximal erlaubte Dicke der Flüssigkeitsschicht, damit die Laserstrahlung noch hindurch kommt, kleiner ist als die minimal notwendige Dicke, damit die Werkstückoberfläche nicht stellenweise austrocknet. Wird nämlich eine Flüssigkeitsschicht erzeugt, welche genügend dick ist, dass keine Ablagerungen entstehen können, kommt die Laserstrahlung nicht mehr durch die Flüssigkeitsschicht hindurch. Wird sie jedoch genügend dünn gewählt, dass die Laserstrahlung mit ausreichender Leistung hindurch kommt, ist nicht mehr gewährleistet, dass die betroffenen Oberflächenbereiche des Werkstücks stets mit der Flüssigkeit überspült sind.

Die Flüssigkeitsschicht wird daher mit Vorteil derart erzeugt, dass ihre Dicke nicht überall gleich ist. Die Flüssigkeitsschicht wird bei einer bevorzugten Ausführungsform der Erfindung derart erzeugt, dass ihre Dicke in einem Bereich rund um den Arbeitspunkt, nachfolgend als Arbeitsbereich bezeichnet, kleiner ist als ihre Dicke ausserhalb des Arbeitsbereiches. Die Dicke der Flüssigkeitsschicht im Arbeitsbereich wird nachfolgend als erste Dicke bezeichnet und liegt wie weiter oben erwähnt unter 1 mm. Die Dicke der Flüssigkeitsschicht ausserhalb des Arbeitsbereichs wird als zweite Dicke bezeichnet und liegt vorzugsweise über 1 mm, insbesondere zwischen 1 mm und 5 mm.

Indem nun auf der Oberfläche des Werkstücks eine Flüssigkeitsschicht erzeugt wird, welche im Bereich des Bearbeitungspunktes dünner ist als ausserhalb des Arbeitsbereiches, können elegant gleichzeitig beide Forderungen erfüllt werden. Im Arbeitsbereich und insbesondere im Arbeitspunkt wird die Dicke der Flüssigkeitsschicht derart gewählt, dass eine ausreichende Laserleistung auf die Werkstückoberfläche aufgebracht werden kann. Die Dicke der Flüssigkeitsschicht ausserhalb des Arbeitsbereiches wird derart gewählt, dass kein Bereich der Werkstückoberfläche austrocknet und dass keine Materialpartikel in flüssigem, teilweise flüssigem oder festem Zustand die Flüssigkeitsschicht durchdringen können. Gleichzeitig ist auch sicher gestellt, dass sich auf der Oberfläche des Werkstücks in dem Bereich, in welchem es bearbeitet wird, immer eine Flüssigkeitsschicht befindet, welche das Werkstück kühlt. Ebenso können allfällige Dämpfe und Gerüche, welche bei der Bearbeitung des Werkstücks entstehen, effektiv gebunden werden. Die optischen Abbildungsbedingungen werden durch die geringe Dicke der Flüssigkeitsschicht im Arbeitsbereich nicht oder nur unwesentlich beeinflusst bzw. verschlechtert.

Zur Erzeugung der Flüssigkeitsschicht können verschiedenste Flüssigkeiten wie beispielsweise Öle, insbesondere Öle aus der Silikongruppe oder Flüssigkeiten, wie sie bei Flüssigkeitsfasern eingesetzt werden, verwendet werden. Typischerweise wird zur Erzeugung der Flüssigkeitsschicht dieselbe Flüssigkeit verwendet wie für den Flüssigkeitsstrahl, in welchen die Laserstrahlung eingekoppelt ist. Mit Vorteil wird Wasser verwendet, welches praktisch überall vorhanden, günstig in der Beschaffung und, im Gegensatz zu Ölen, im Allgemeinen als umweltneutral anzusehen ist.

In Abhängigkeit des Werkstoffmaterials bzw. der Bearbeitungsart kann das Wasser, das für die Erzeugung der Flüssigkeitsschicht verwendet wird, auch noch gereinigt und/oder deionisiert werden. Dadurch kann beispielsweise auch verhindert werden, dass das Werkstück durch das Wasser bzw. irgendwelchen Inhaltsstoffen des Wassers wie z.B. gelöste Salze, verunreinigt wird. Es ist auch möglich, das Wasser (z.B. auch das gereinigte und/oder deionisierte Wasser) elektrisch leitfähig zu machen, indem beispielsweise Kohlendioxid ($CO_2$) eingeleitet wird. Dies ist insbesondere dann von Vorteil, wenn der Auswurf elektrisch geladen ist und/oder wenn bei der Bearbeitung des Werkstoffs elektrostatische Spannungen entstehen, welche abgeleitet werden sollen.

Die Verwendung einer elektrisch leitfähigen Flüssigkeit wie beispielsweise elektrisch leitfähiges Wasser hat einen weiteren Vorteil. Bauteile, die auf elektrostatische Spannungen empfindlich sind, beispielsweise mikroelektronische Chips, die aus einem Wafer ausgeschnitten werden, können durch die Verwendung einer elektrisch leitfähigen Flüssigkeit nämlich vor elektrostatischen Ladungen geschützt werden, da derartige Ladungen durch die Flüssigkeitsschicht abgeleitet werden.

Das erfindungsgemässe Verfahren wird bevorzugt eingesetzt, um Wafer zu bearbeiten. Es wird insbesondere bevorzugt eingesetzt, um aus Siliziumwafern, auf welchen typischerweise eine Vielzahl einzelner Chips realisiert sind, die einzelnen Chips auszuschneiden. Gegenüber dem Zerteilen der Wafer mittels einer Säge lässt sich die thermische und mechanische Beanspruchung der Wafer bei der Bearbeitung mit einem in einem Wasserstrahl geführten Laser deutlich verringern. Dadurch entsteht weniger Ausschuss und es kann effizienter produziert werden.

Die Erfindung eignet sich allerdings auch zum Bearbeiten beliebiger anderer Werkstücke. Die Bearbeitungspalette reicht von Schneiden und Bohren von Stoffen über Markieren bis hin zu Materialabtragung oder Oberflächenbehandlung wie z.B. aufrauhen, strukturieren oder abtragen von Dünnschichten der Werkstückoberfläche. Zur Bearbeitung eignen sich neben Halbleitermaterialien auch nahezu alle anderen Materialien wie beispielsweise Metalle (Stahl, Stahllegierungen, NE-Metalle), aber auch Kunststoffe, Keramiken oder biologische Materialien und Gewebe.

Um die Austrocknung des Werkstücks zu vermeiden, würde es grundsätzlich ausreichen, für eine genügende Dicke, d.h. für eine bestimmte Minimaldicke der Flüssigkeitsschicht, zu sorgen. Um das Austrocknen des Werkstücks möglichst effektiv zu verhindern, wird die zweite Dicke der Flüssigkeitsschicht bei einer vorteilhaften Ausbildungsvariante der Erfindung reguliert, indem beispielsweise die zugeführte und/oder die abfliessende Flüssigkeitsmenge variiert wird. Um die abfliessende Wassermenge zu beeinflussen, kann beispielsweise der Werkstückhalter oder gar das Werkstück selber eine spezielle Form aufweisen. Der Werkstückhalter kann z.B. derart ausgebildet sein, dass sein Rand im Vergleich zum Werkstück erhöht ist, sodass die abfliessende Flüssigkeit bis auf die gewünschte Höhe gestaut wird (konvexe Oberfläche). Ist die Oberfläche hingegen konkav ausgebildet, fliesst die Flüssigkeit schneller ab und die Flüssigkeitsschicht wird dünner.

Die Dicke der Flüssigkeitsschicht wird aber vorzugsweise auch beeinflusst, indem der Flüssigkeit Stoffe zugesetzt werden, welche deren Oberflächenspannung beeinflussen, d.h. je nach Anwendung erhöhen oder erniedrigen. Die Dicke der Flüssigkeitsschicht steigt mit einer Erhöhung der Oberflächenspannung. Je nach verwendeter Flüssigkeit können dies sehr unterschiedliche Stoffe sein. Bei der Verwendung von Wasser können zur Erniedrigung der Oberflächenspannung beispielsweise Tenside beigefügt werden.

Die Erzeugung der Flüssigkeitsschicht kann grundsätzlich auf verschiedene Arten erfolgen. Dies könnte beispielsweise erfolgen, indem zunächst eine regelmässig dicke Schicht erzeugt wird, deren Dicke im Bereich des Arbeitspunktes z.B. durch einen darauf gerichteten Luftstrahl reduziert wird. Wird die Strömungsgeschwindigkeit und der Druck des Luftstrahls geeignet gewählt, verdrängt dieser einen Teil der Flüssigkeit im Arbeitspunkt und schafft auf diese Weise die dünnere Flüssigkeitsschicht im Arbeitsbereich. Bei dieser Variante kann die so erzeugte dünne Flüssigkeitsschicht allerdings Unregelmässigkeiten aufweisen, was zu einer unerwünscht unregelmässigen Bearbeitung des Werkstücks führen kann. Ebensowenig wäre garantiert, dass die Flüssigkeit im Arbeitsbereich und insbesondere im Arbeitspunkt schiessend fliesst. Zudem kann auch der Flüssigkeitsstrahl und damit die darin eingekoppelte Laserstrahlung durch einen solchen Luftstrom gestört werden.

Bei einer bevorzugten Variante wird die Flüssigkeitsschicht mit einer ersten Flüssigkeitszuführvorrichtung, beispielsweise einer Düse oder einem Rohr, erzeugt. Die Flüssigkeitsschicht wird derart erzeugt, dass die Flüssigkeit in der Nähe des Arbeitspunktes auf das Werkstück aufgebracht wird. Nachfolgend wird in diesem Zusammenhang von einem aufgebrachten Flüssigkeitsstrahl gesprochen, wobei dieser Begriff einzelne Flüssigkeitsstrahlen oder eine Mehrzahl von Einzelstrahlen beliebigen Querschnitts umfassen soll. D.h. unter diesem Begriff sollen nicht nur Flüssigkeitsstrahlen mit kreisförmigem Querschnitt verstanden werden. Auch Flüssigkeitsvorhänge, wie sie beispielsweise von Schwall- und Fächerdüsen erzeugt werden, sollen unter diesem Begriff subsummiert werden.

Trifft ein solcher Flüssigkeitsstrahl auf die Werkstückoberfläche, fliesst die Flüssigkeit auf der Oberfläche in radialer Richtung ab, wobei die Fliessgeschwindigkeit mit zunehmender Entfernung vom Auftreffpunkt abnimmt. Die höchste Fliessgeschwindigkeit und die kleinste Schichtdicke weist die Schicht nahe dem Auftreffpunkt auf. Unterschreitet die Fliessgeschwindigkeit bei zunehmender Entfernung vom Auftreffpunkt eine kritische Geschwindigkeit, erhöht sich die Dicke der Flüssigkeitsschicht.

Bei einer weiteren bevorzugten Ausführungsform der Erfindung wird zur Erzeugung der Flüssigkeitsschicht eine zweite Flüssigkeitszuführvorrichtung, beispielsweise eine oder eine Mehrzahl von Düsen, verwendet. Die zweite Flüssigkeitszuführvorrichtung ist derart ausgebildet, dass auf der Oberfläche des Werkstücks eine träge, regelmässige Flüssigkeitsschicht der zweiten Dicke entsteht, wobei träge in diesem Zusammenhang bedeutet, dass diese Flüssigkeitsschicht zwar fliesst, dass die Fliessgeschwindigkeit jedoch klein ist. Beide Flüssigkeitszuführvorrichtungen können sowohl einzeln als auch in Kombination verwendet werden. Werden sie einzeln verwendet, wird in den meisten Fällen eine gleichmässig dicke Flüssigkeitsschicht erzeugt.

Mit Vorteil werden jedoch beide Flüssigkeitszuführvorrichtungen gleichzeitig verwendet. D.h. mit der zweiten Flüssigkeitszuführvorrichtung wird eine träge Flüssigkeitsschicht der zweiten Dicke erzeugt und gleichzeitig wird nun mit der ersten Flüssigkeitszuführvorrichtung in der Nähe des Arbeitspunktes - wie soeben beschrieben - ein Flüssigkeitsstrahl auf das Werkstück aufgebracht, um im Arbeitsbereich die Dicke der Flüssigkeitsschicht auf die erste Dicke zu reduzieren. Dieser Flüssigkeitsstrahl beeinflusst das Strömungsverhalten der Flüssigkeitsschicht derart, dass diese in dem Arbeitsbereich schneller strömt als ausserhalb dieses Bereichs. Dadurch wiederum reduziert sich die Höhe der Flüssigkeitsschicht im Arbeitsbereich, wobei sie ausserhalb davon im Wesentlichen unbeeinflusst bleibt.

Die Eigenschaften des Flüssigkeitsstrahls, insbesondere dessen Auftreffwinkel auf der Werkstückoberfläche sowie dessen Durchflussmenge werden nun so gewählt, dass das Strömungsverhalten der Flüssigkeitsschicht derart beeinflusst wird, dass sich die Flüssigkeit in dem Arbeitsbereich um den Arbeitspunkt schiessend und ausserhalb dieses Bereichs strömend bewegt. Durch das Auftreffen des Flüssigkeitsstrahls auf der Flüssigkeitsschicht wird in diesem Bereich das Strömungsgleichgewicht der Flüssigkeitsschicht gestört und die Flüssigkeit fliesst auf der Werkstückoberfläche rund um den Auftreffpunkt des Flüssigkeitsstrahls schiessend ab. Diese schiessende Bewegung wird in einem bestimmten Bereich um den Auftreffpunkt herum aufrechterhalten und geht danach nahezu sprunghaft in eine strömende Bewegung der Flüssigkeit über. Dieser mehr oder weniger abrupte Wechsel von schiessender zu strömender Bewegung bzw. umgekehrt wird als Wechselsprung bezeichnet.

Es gibt viele Parameter um die Eigenschaften des Flüssigkeitsstrahls und damit die Grösse des Arbeitsbereiches sowie die erste Dicke der Flüssigkeitsschicht im Arbeitsbereich zu beeinflussen. Hierzu eignen sich insbesondere sein Durchmesser, sein Auftreffwinkel auf die träge Flüssigkeitsschicht oder seine Durchflussmenge, welche über den Querschnitt mit der Geschwindigkeit und dem Eingangsdruck des Flüssigkeitsstrahls zusammenhängt. Um die Grösse des Arbeitsbereiches sowie die erste Dicke der Flüssigkeitsschicht im Arbeitsbereich zu regulieren, können grundsätzlich sämtliche dieser Parameter praktisch beliebig variiert werden.

Typischerweise wird jedoch der Querschnitt des Flüssigkeitsstrahls während der Bearbeitung des Werkstücks unverändert beibehalten, sodass die Übergänge zwischen strömender und schiessender Flüssigkeit und damit die Grösse des Arbeitsbereiches sowie die erste Dicke der Flüssigkeit bevorzugt durch Variieren des Auftreffwinkels und der Durchflussmenge des Flüssigkeitsstrahls reguliert werden.

Selbstverständlich kann auch der Querschnitt des Flüssigkeitsstrahls variiert werden, indem beispielsweise in einer Bearbeitungspause eine Düse oder ein Rohr durch eine andere Düse oder ein anderes Rohr mit kleinerem oder grösserem Querschnitt ausgewechselt wird.

Die oben genannten Parameter können, wie bereits erwähnt, im Prinzip fast beliebig variiert werden. Der Auftreffwinkel des Flüssigkeitsstrahls, d.h. der Winkel, welcher zwischen der typischerweise horizontalen Oberfläche der Flüssigkeitsschicht und dem Flüssigkeitsstrahl im Auftreffpunkt gebildet wird, kann z.B. zwischen 0 Grad und 90 Grad praktisch beliebig gewählt werden. Wenn bereits eine (träge) Flüssigkeitsschicht vorhanden ist, ist es im Prinzip sogar möglich, den Flüssigkeitsstrahl nicht von oben auf die Flüssigkeitsschicht aufzubringen, sondern quasi unter der Oberfläche einzuspeisen. Allerdings ist es in diesen Fällen schwierig, im Arbeitsbereich die gewünschte schiessende Strömung zu erreichen.

Auch die Durchflussmenge des Wasserstrahls (definiert als Flüssigkeitsmenge pro Zeiteinheit) kann fast beliebig zwischen sehr kleinen Durchflussmengen wie etwa einem Milliliter pro Minute und sehr hohen Durchflussmengen wie etwa zehn Liter pro Minute gewählt werden. Auch der Querschnitt des Flüssigkeitsstrahls kann im Prinzip von sehr klein, beispielsweise 0,01 Millimeter Durchmesser, bis sehr gross, beispielsweise bis 50 Millimeter oder gar 100 Millimeter Durchmesser, gewählt werden.

Um die gewünschten Strömungsverhältnisse mit der schiessenden und der strömenden Bewegung der Flüssigkeit zu erreichen, wird der Flüssigkeitsstrahl bei einer bevorzugten Ausführungsform der Erfindung allerdings derart erzeugt, dass er bei einer Durchflussmenge von 20 Milliliter pro Minute bis 500 Milliliter pro Minute einen Durchmesser zwischen 0,5 Millimeter und 4 Millimeter aufweist, wobei er von oben in einem Auftreffwinkel zwischen 45 Grad und 90 Grad auf die Flüssigkeitsschicht aufgebracht wird.

Die erfindungsgemässe Vorrichtung ist durch die Merkmale des Anspruchs 12 definiert. Neben den Mitteln zur Erzeugung der auf die Oberfläche des Werkstücks gerichteten, in den Flüssigkeitsstrahl eingekoppelten und darin geführten Laserstrahlung umfasst die Vorrichtung gemäss der Erfindung Mittel zur Erzeugung einer fliessenden Flüssigkeitsschicht auf der Oberfläche des Werkstücks, welche derart ausgebildet sind, dass die Flüssigkeitsschicht in einem Arbeitsbereich um den Arbeitspunkt herum eine Dicke unter 1 Millimeter, insbesondere zwischen 0.01 Millimeter und 0.5 Millimeter aufweist.

Diese Mittel zur Erzeugung der Flüssigkeitsschicht sind wie bereits erwähnt vorzugsweise derart ausgebildet, dass die damit erzeugte Flüssigkeitsschicht im Arbeitsbereich schiessend fliesst und die Dicke der Flüssigkeitsschicht unter der maximalen Dicke von 1 mm liegt.

Diese Mittel zur Erzeugung der Flüssigkeitsschicht sind weiter vorzugsweise derart ausgebildet, dass die erste Dicke der erzeugten Flüssigkeitsschicht im Arbeitsbereich um den Arbeitspunkt kleiner ist als die zweite Dicke der Flüssigkeitsschicht ausserhalb dieses Arbeitsbereichs. Wie bereits erwähnt liegt die zweite Dicke über 1 mm, vorzugsweise zwischen 1 mm und 5 mm.

Bei einer weiteren bevorzugten Ausführungsform der erfindungsgemässen Vorrichtung umfasst diese eine zweite Flüssigkeitszuführvorrichtung. Diese dient zur Erzeugung einer trägen Flüssigkeitsschicht der zweiten Dicke auf der Oberfläche des Werkstücks. Die derart erzeugte Flüssigkeitsschicht wird entweder unverändert als im Wesentlichen überall gleich dicke Flüssigkeitsschicht beibehalten oder es wird, wie vorgängig bereits beschrieben, der schiessende Bereich der Flüssigkeitsschicht erzeugt, indem der erwähnte Flüssigkeitsstrahl in der Nähe des Arbeitspunktes auf die Flüssigkeitsschicht aufgebracht wird.

Die Vorrichtung kann zur Bearbeitung einer Vielzahl von Materialien und zur Durchführung einer Vielzahl von Bearbeitungsarten ausgebildet sein. Ein bevorzugtes Einsatzgebiet für derartige Vorrichtungen ist jedoch das Bearbeiten von Wafern und insbesondere das Ausschneiden einer Vielzahl von Chips aus einem Siliziumwafer.

Zur Erzeugung der Flüssigkeitsschicht umfasst die Vorrichtung vorzugsweise eine erste Flüssigkeitszuführvorrichtung, welche derart ausgebildet ist, dass die Flüssigkeit in der Nähe des Arbeitspunktes auf das Werkstück aufbringbar ist. Auch diese erste Flüssigkeitszuführvorrichtung kann einerseits zur Erzeugung einer gleichmässig dicken bzw. dünnen Flüssigkeitsschicht auf der Werkstückoberfläche verwendet werden. Andererseits kann sie zusammen mit der zweiten Flüssigkeitszuführvorrichtung auch wie beschrieben zur Erzeugung der Flüssigkeitsschicht mit unterschiedlichen Dicken im Arbeitsbereich bzw. ausserhalb davon verwendet werden.

Diese erste Flüssigkeitszuführvorrichtung ist mit Vorteil derart ausgebildet, dass ein Flüssigkeitsstrahl erzeugbar ist, dessen Auftreffwinkel auf die Werkstückoberfläche und dessen Durchflussmenge variierbar sind. Dadurch kann der Flüssigkeitsstrahl variiert werden, sodass die Flüssigkeitsschicht mit einer in dem Arbeitsbereich schiessenden und mit einer ausserhalb des Arbeitsbereichs strömenden Fliessbewegung erzeugbar ist.

Aus der nachfolgenden Detailbeschreibung und der Gesamtheit der Patentansprüche ergeben sich weitere vorteilhafte Ausführungsformen und Merkmalskombinationen der Erfindung.

## Kurze Beschreibung der Zeichnungen

Die zur Erläuterung des Ausführungsbeispiels verwendeten Zeichnungen zeigen:

Fig. 1     eine schematische Darstellung einer erfindungsgemässen Vorrichtung;

Fig. 2     eine Detailansicht der Vorrichtung aus Fig. 1;

Fig. 3 eine schematische Darstellung eines weiteren Ausführungsbeispiels der Erfindung.

Grundsätzlich sind in den Figuren gleiche Teile mit gleichen Bezugszeichen versehen.

**Wege zur Ausführung der Erfindung**

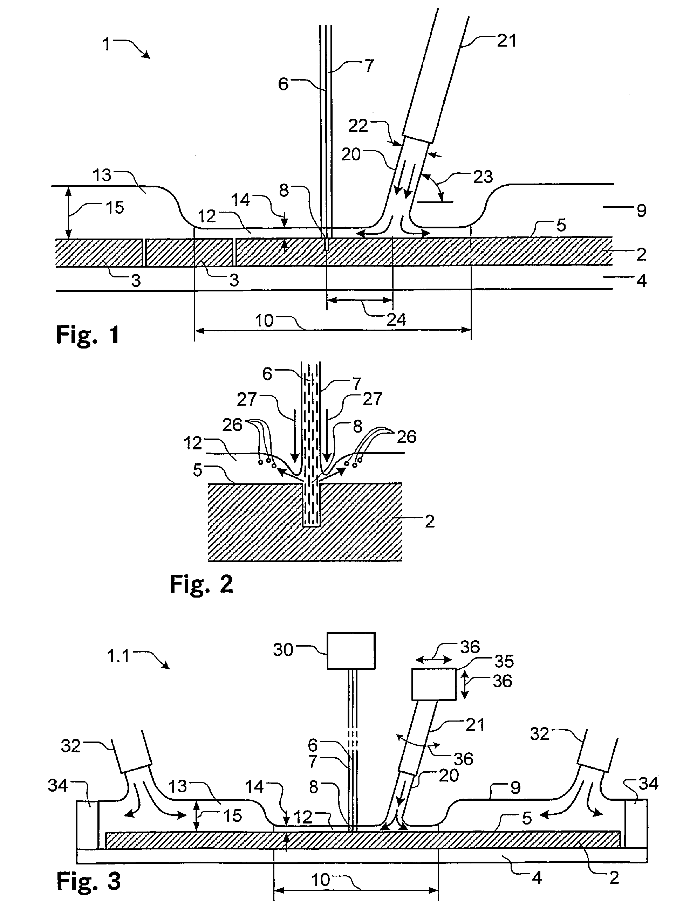

Fig. 1 zeigt eine schematische Darstellung eines Teils einer erfindungsgemässen Vorrichtung 1 zum Bearbeiten eines Werkstücks, im vorliegenden Beispiel eines Wafers 2. Bei dem Wafer handelt es sich um eine Siliziumscheibe, auf welcher in bekannter Weise eine Vielzahl integrierter Schaltkreise realisiert sind. Die Bearbeitung des Wafers 2 besteht nun im Ausschneiden dieser Schaltkreise, auch Chips 3 genannt, aus dem Wafer 2. Derartige Wafer sind in der Regel rund, haben einen Durchmesser in der Grössenordnung von einigen Dutzend bis einigen Hundert Millimetern und eine Dicke im Bereich einiger Dutzend bis einige Hundert Mikrometer.

Der Wafer 2 ist auf einem Träger 4 befestigt. Der Wafer 2 wird beispielsweise durch einen Druckunterschied ober- und unterhalb des Trägers 4 auf diesem gehalten. Oberhalb des Trägers 4 herrscht beispielsweise der Umgebungs- oder Atmosphärendruck. Unterhalb des Trägers 4 wird ein mehr oder weniger starker Unterdruck erzeugt. Da der Träger 4 selber luftdurchlässig, z.B. porös ausgebildet ist, wird der Wafer 2 auf dessen Oberfläche sozusagen angesaugt und festgehalten. Zusätzlich oder stattdessen kann der Wafer 2 mit Hilfe einer Klebefolie auf dem Träger 4 aufgeklebt werden, wobei die Folie gegebenenfalls auch luftdurchlässig ausgebildet ist.

Zum Schneiden des Wafers 2 wird ein Laserstrahl 6, beispielsweise ein Nd:YAG Laser mit einer Wellenlänge von 1.06 Mikrometer und einer Leistung von 100 Watt verwendet. Je nach konkreter Anwendung kann die Laserleistung selbstverständlich auch von einigen wenigen Watt bis hinauf in den Kilowatt-Bereich variiert werden. Ebenso kann je nach Art der Anwendung ein anderer Laser verwendet werden. Der Laserstrahl 6 wird auf einen Arbeitspunkt 8 auf der Oberfläche 5 des Wafers 2 gerichtet wobei dies in bekannter Weise zum Abtrag von Wafermaterial im Arbeitspunkt 8 und gewünschtenfalls schliesslich zur vollständigen Durchtrennung des Wafers 2 führt. Zum Schneiden des Wafers 2 werden der Laserstrahl 6 und der Wafer 2 relativ zueinander bewegt, wobei dies durch Fixieren des Wafers 2 und Verschieben des Laserstrahls 6, durch Fixieren des Laserstrahls 6 und Verschieben des Wafers 2 wie auch durch Verschieben sowohl des Laserstrahls 6 als auch des Wafers 2 erfolgen kann.

In dem in Fig. 1 dargestellten Beispiel ist der Laserstrahl 6 in bekannter Weise in einen Flüssigkeitsstrahl 7 eingekoppelt, welcher für den Laserstrahl 6 als Lichtleiter wirkt. Der Flüssigkeitsstrahl 7 wird mit einem Druck im Bereich von einigen Bar bis zu einigen tausend Bar, vorzugsweise im Bereich von 50 Bar bis 1'000 Bar erzeugt. Der Durchmesser des Flüssigkeitsstrahls 7 liegt im Submillimeter-Bereich, typischerweise zwischen 5 Mikrometer und 500 Mikrometer, vorzugsweise zwischen 20 Mikrometer und 100 Mikrometer.

Der Flüssigkeitsstrahl 7 wird, insbesondere bei Verwendung eines Nd:YAG Lasers, vorzugsweise mit Wasser erzeugt, welchem gegebenenfalls andere Stoffe beigemischt werden, um die Strahleigenschaften zu beeinflussen. Neben Wasser können aber auch andere elektrisch leitende oder elektrisch nicht leitende Flüssigkeiten verwendet werden. Öle, insbesondere Silikonöle, eignen sich beispielsweise auch zur Erzeugung des Flüssigkeitsstrahls 7.

Die Wahl der Flüssigkeit hängt auch zusammen mit dem verwendeten Laser, da die Absorption der Laserstrahlung stark von der Art der Flüssigkeit abhängen kann. D.h. es ist darauf zu achten, dass die für den Flüssigkeitsstrahl 7 verwendete Flüssigkeit die verwendete Laserstrahlung nicht oder nur wenig absorbiert.

Auf der Oberfläche 5 des Wafers 2 bzw. der Chips 3 wird nun erfindungsgemäss eine Flüssigkeitsschicht 9 erzeugt, welche in einem Bereich um den Arbeitspunkt 8 herum, dem sogenannten Arbeitsbereich 10 dünner ist als ausserhalb des Arbeitsbereiches 10. Die Flüssigkeitsschicht 9 im Arbeitsbereich 10 wird nachfolgend als Arbeitsschicht 12 der Dicke 14 und jener Bereich der Flüssigkeitsschicht 9 ausserhalb des Arbeitsbereiches 10 als Spülschicht 13 der Dicke 15 bezeichnet.

Erzeugt wird die unterschiedlich dicke Flüssigkeitsschicht 9 mittels eines Flüssigkeitsstrahls 20, welcher beispielsweise mit Hilfe eines Rohres 21 auf die Oberfläche 5 des Wafers 2 aufgebracht wird. Der Flüssigkeitsstrahl 20 wird in der Nähe des Arbeitspunktes 10 auf den Wafer 2 aufgebracht, wobei die Distanz 24 zum Arbeitspunkt 10 weder zu gross, noch zu klein gewählt werden darf. Allerdings ist die Bandbreite für die konkrete Wahl der Distanz 24 ziemlich gross. D.h. die Distanz 24 kann sowohl sehr klein als auch sehr gross gewählt werden. Es ist lediglich zu beachten, dass sich der Arbeitspunkt 8 innerhalb des Arbeitsbereichs 10, d.h. innerhalb des Bereichs der Flüssigkeitsschicht mit der Dicke 14 befindet. Auch die Geschwindigkeit der Relativbewegung des Laserstrahls 6 und des Wafers 2 kann die Wahl der Distanz 24 beeinflussen, damit der Arbeitspunkt 8 in jedem Fall innerhalb des Arbeitsbereichs 10 liegt.

Der Fluss der aufgebrachten Flüssigkeit ist durch die Pfeile angedeutet. Der Auftreffwinkel 23 und die Durchflussmenge des Flüssigkeitsstrahls 20 können variiert werden. Sie werden derart gewählt, dass sich die Flüssigkeit in der Arbeitsschicht 12 schiessend (Froude-Zahl grösser als 1) und in der Spülschicht 13 strömend (Froude-Zahl kleiner als 1) bewegt, wobei der Übergang von der Arbeitsschicht 12 zur Spülschicht 13 mehr oder weniger sprungartig verläuft.

Bei einem runden Wafer 2 mit einem Durchmesser von 200 Millimetern bis 300 Millimetern wird die Distanz 24 im Bereich von etwa 5 Millimetern bis 50 Millimetern gewählt. Das Rohr 21 ist derart ausgebildet, dass der Durchmesser 22 des Flüssigkeitsstrahls 20 zwischen 0,5 Millimeter und 5 Millimeter liegt. Mit einem Auftreffwinkel 23 zwischen 45 Grad und 90 Grad und einer Durchflussmenge des Flüssigkeitsstrahls 20 zwischen 20 Milliliter pro Minute und 500 Milliliter pro Minute liegt die Dicke 14 der Arbeitsschicht 12 im Bereich von 0,01 Millimeter bis 0,5 Millimeter und die Dicke 15 der Spülschicht 13 im Bereich von 0,5 Millimeter bis 5 Millimeter.

Fig. 2 zeigt eine Detailansicht des Wafers 2 im Bereich des Arbeitspunktes 8. Der im Flüssigkeitsstrahl 7 eingekoppelte Laserstrahl 6 füllt den Flüssigkeitsstrahl 7 vollständig aus, was durch die gestrichelten Linien angedeutet ist. Es ist zu beachten, dass der Flüssigkeitsstrahl 7 die Luft an seiner Oberfläche mitreisst. Die vom Flüssigkeitsstrahl 7 mitgerissene Luft ist durch die Pfeile 27 dargestellt. Diese mitgerissene Luft verdrängt zusammen mit dem Flüssigkeitsstrahl 7 beim Auftreffen auf die Arbeitsschicht 12 einen Teil der Flüssigkeit der Arbeitsschicht 12 rund um den Arbeitspunkt 8 herum, sodass der Flüssigkeitsstrahl 7 mit dem darin eingekoppelten Laserstrahl 6 quasi verlängert und praktisch bis auf die Oberfläche des Wafers 2 geführt wird. Der Flüssigkeitsstrahl 7 ragt sozusagen in den Arbeitsbereich 12 hinein und reicht fast bis zur Werkstückoberfläche herunter. Dadurch kann der Laserstrahl 6 länger in dem Flüssigkeitsstrahl 7 geführt werden, was geringere Energieverluste des Laserstrahls 6 zur Folge hat.

Der Laserstrahl 6 durchquert also die Arbeitsschicht 12, trifft auf die Oberfläche des Wafers 2 und trägt dort Material ab, indem dieses durch die vom Laserstrahl 6 zugeführte Energie aufschmilzt. Hierbei entstehen kleine Partikel 26, der sogenannte Auswurf, welche aus geschmolzenem Wafermaterial bestehen können und von der schiessend fliessenden Arbeitsschicht 12 sogleich gekühlt und weggespült werden. Dadurch wird verhindert, dass sich die Partikel 26 auf der Oberfläche 5 des Wafers 2 absetzen und sich dort wieder mit dem Wafer 2 verbinden. Diese Partikel 26 werden von der Arbeitsschicht 12 bis zur Spülschicht 13 und von dieser vom Wafer weggespült. Durch die gewählte Dicke 15 der Spülschicht 13 ist sichergestellt, dass kein Bereich der Waferoberfläche austrocknet, sondern jederzeit mit einer Schicht der Flüssigkeit bedeckt ist. Dadurch kann das Absetzen der Partikel 26 auch im äusseren Bereich des Wafers 2 wirksam verhindert werden. Das Resultat ist eine vollkommen reine Oberfläche 5 des Wafers 2. Eine nachträgliche Reinigung ist nicht mehr notwendig.

Fig. 3 zeigt eine etwas umfassendere Darstellung eines weiteren Beispiels für eine erfindungsgemässe Vorrichtung 1.1. Der im Flüssigkeitsstrahl 7 eingekoppelte Laserstrahl 6 wird mit Hilfe einer im Stand der Technik bekannten Strahlerzeugungsvorrichtung 30 erzeugt. Diese umfasst nicht nur die (nicht dargestellten) Mittel zur Erzeugung der Laserstrahlung und damit des Laserstrahls 6 im gewünschten Wellenlängenbereich und mit der erforderlichen Energie, sie umfasst auch die (nicht dargestellten) Mittel zur Erzeugung des Flüssigkeitsstrahls 7 mit den gewünschten Eigenschaften sowie die (nicht dargestellten) Mittel zum Einkoppeln des Laserstrahls 6 in den Flüssigkeitsstrahl 7.

Zur Erzeugung der Flüssigkeitsschicht 9 auf der Oberfläche 5 des Wafers 2 ist bei diesem Beispiel neben der Flüssigkeitszuführvorrichtung 35 mit dem Rohr 21 eine weitere Flüssig-keitszuführvorrichtung vorgesehen, welche eine oder eine Mehrzahl von Wasserauslässen wie beispielsweise Röhren, Schläuche oder spezielle Düsen umfasst, wobei in Fig. 4 zwei Düsen 32 dargestellt sind. Die Düsen 32 erzeugen die Spülschicht 13. Deren Dicke 15 wird kontrolliert durch die Höhe der Umrandung 34, welche als Teil des Trägers 4 oder als separater Teil der Vorrichtung 1.1 ausgebildet sein kann. Die Umrandung 34 ist beispielsweise derart ausgebildet, dass überschüssige Flüssigkeit durch spezielle Abflüsse oder über den Rand der Umrandung 34 abläuft. Um die Arbeitsschicht 12 der geringeren Dicke 14 zu erzeugen, umfasst auch die Vorrichtung 1.1 eine Flüssigkeitszuführvorrichtung 35, mit welcher ein Flüssigkeitsstrahl 20 erzeugt und mit dem Rohr 21 auf die Waferoberfläche aufgebracht werden kann. Trifft der Flüssigkeitsstrahl 20 auf die Spülschicht 13, beeinflusst dies die Strömungsverhältnisse in der Flüssigkeitsschicht 9 derart, dass sich um den Auftreffpunkt des Flüssigkeitsstrahls 20 herum wiederum eine dünne Arbeitsschicht 12 mit schiessender Bewegung der Flüssigkeit ausbildet. Auch hier definiert dieser Bereich den sogenannten Arbeitsbereich. Um die Eigenschaften des Flüssigkeitsstrahls 20 zu beeinflussen, ist die Flüssigkeitszuführvorrichtung 35 beispielsweise derart ausgebildet, dass sowohl die Durchflussmenge des Flüssigkeitsstrahls 20 als auch die horizontale und vertikale Position sowie der Auftreffwinkel 23 des Flüssigkeitsstrahls 20 variierbar sind. Dies ist durch die Pfeile 36 angedeutet. Die Flüssigkeitszuführvorrichtung 35 ist bewegungsmässig bevorzugt mit der Strahlerzeugungsvorrichtung 30 gekoppelt, sodass der Auftreffpunkt des Flüssigkeitsstrahls 20 in Bezug auf den Arbeitspunkt 8 im Wesentlichen konstant bleibt.

Mittels der Düsen 32 bzw. des Rohrs 21 können durchaus verschiedene Flüssigkeiten auf den Wafer 2 aufgebracht werden. Typischerweise handelt es sich jedoch um dieselbe Flüssigkeit.

Die zur Erzeugung der Flüssigkeitsschicht auf der Waferoberfläche notwendige Flüssigkeit kann auch auf andere Weise auf den Wafer aufgebracht werden. Es wäre beispielsweise möglich, den Flüssigkeitsstrahl 20, welcher den schiessend strömenden Arbeitsbereich erzeugt, mit Hilfe mehrerer Einzelstrahlen zu erzeugen. Denkbar wäre beispielsweise auch eine Vorrichtung, die einen ringförmigen Flüssigkeitsstrahl erzeugt, der in einem bestimmten Abstand rund um den Laserstrahl herum angeordnet ist. Anstelle der Düsen 32 könnte zur Erzeugung der Spülschicht 13 beispielsweise auch eine Vielzahl von Düsen in die Umrandung 34 integriert sein.

Zusammenfassend ist festzustellen, dass es die Erfindung erlaubt, den beim Bearbeiten eines Werkstücks mit einer Laserstrahlung entstehenden Auswurf mit einer genügend dicken Flüssigkeitsschicht wegzuspülen und gleichzeitig sicher zu stellen, dass die Flüssigkeitsschicht im Bereich des Arbeitspunktes genügend dünn ist, dass eine zur Bearbeitung des Werkstücks ausreichende Energiemenge der Laserstrahlung auf das Werkstück aufgebracht werden kann.

**Patentansprüche**

1. Verfahren zur Bearbeitung eines Werkstücks (2) mit einer in einem Flüssigkeitsstrahl (7) eingekoppelten und geführten Laserstrahlung (6), bei welchem der Flüssigkeitsstrahl (7) mit der Laserstrahlung auf eine Oberfläche (5) des Werkstücks gerichtet und das Werkstück in einem Arbeitspunkt (8) bearbeitet wird, **dadurch gekennzeichnet, dass** auf der Oberfläche des Werkstücks mit einer Flüssigkeit eine fliessende Flüssigkeitsschicht (9) derart erzeugt wird, dass sie in einem Arbeitsbereich (10) um den Arbeitspunkt (8) herum eine Dicke unter 1 Millimeter, insbesondere zwischen 0.01 Millimeter und 0.5 Millimeter aufweist.

2. Verfahren nach Anspruch 1, **dadurch gekennzeichnet, dass** die Flüssigkeitsschicht (9) derart erzeugt wird, dass sie im Arbeitsbereich (10) schiessend fliesst.

3. Verfahren nach Anspruch 1 oder 2, **dadurch gekennzeichnet, dass** die Flüssigkeitsschicht (9) derart erzeugt wird, dass sie ausserhalb des Arbeitsbereichs (10) strömend fliesst und eine zweite Dicke (15) über 1 Millimeter, insbesondere zwischen 1 Millimeter und 5 Millimeter aufweist.

4. Verfahren nach einem der Ansprüche 1 bis 3, **dadurch gekennzeichnet, dass** die Flüssigkeitsschicht auf der Oberfläche des Werkstücks mit Wasser, insbesondere mit deionisiertem Wasser, erzeugt wird.

5. Verfahren nach einem der Ansprüche 1 bis 4, **dadurch gekennzeichnet, dass** ein Wafer (2) bearbeitet wird, wobei insbesondere ein Siliziumwafer in eine Vielzahl von Chips (3) geschnitten wird.

6. Verfahren nach einem der Ansprüche 1 bis 5, **dadurch gekennzeichnet, dass** die zweite Dicke der Flüssigkeitsschicht reguliert wird, indem der Flüssigkeit oberflächenspannungsbeeinflussende Stoffe beigefügt werden und/oder indem eine zugeführte und/oder abfliessende Flüssigkeitsmenge variiert wird.

7. Verfahren nach einem der Ansprüche 1 bis 6, **dadurch gekennzeichnet, dass** die Flüssigkeitsschicht erzeugt wird, indem mit einer ersten Flüssigkeitszuführvorrichtung (21) die Flüssigkeit in einer Nähe (24) des Arbeitspunktes auf das Werkstück aufgebracht wird.

8. Verfahren nach Anspruch 7, **dadurch gekennzeichnet, dass** mit einer zweiten Flüssigkeitszuführvorrichtung (32) eine träge Flüssigkeitsschicht der zweiten Dicke erzeugt wird, wobei die in der Nähe des Arbeitspunktes aufgebrachte Flüssigkeit die Dicke der Flüssigkeitsschicht in dem Arbeitsbereich auf die erste Dicke reduziert.

9. Verfahren nach Anspruch 7 oder 8, **dadurch gekennzeichnet, dass** die Flüssigkeit mit der ersten Flüssigkeitszuführvorrichtung (21) in einem Strahl (20) auf das Werkstück aufgebracht wird.

10. Verfahren nach Anspruch 9, **dadurch gekennzeichnet, dass** die erste Dicke der Flüssigkeitsschicht und/oder eine Grösse des Arbeitsbereichs reguliert wird indem ein Auftreffwinkel und/oder eine Durchflussmenge des Strahls (20) variiert wird.

11. Verfahren nach Anspruch 10, **dadurch gekennzeichnet, dass** der Strahl mit einem Durchmesser (22) zwischen 0.5 Millimeter und 4 Millimeter erzeugt wird, wobei der Auftreffwinkel des Strahls zwischen 45 Grad und 90 Grad und dessen Durchflussmenge zwischen 1 Milliliter pro Minute und 10 Liter pro Minute, insbesondere zwischen 20 Milliliter pro Minute und 500 Milliliter pro Minute variiert wird.

12. Vorrichtung (1) zur Bearbeitung eines Werkstücks (2) mit einer Laserstrahlung (6), welche auf eine Oberfläche (5) des Werkstücks richtbar ist, wobei das Werkstück in einem Arbeitspunkt (8) bearbeitbar und die Laserstrahlung in einem Flüssigkeitsstrahl (7) eingekoppelt und geführt ist, **dadurch gekennzeichnet, dass** die Vorrichtung Mittel (21) zur Erzeugung einer fliessenden Flüssigkeitsschicht (9) auf der Oberfläche des Werkstücks umfasst, welche derart ausgebildet sind, dass die Flüssigkeitsschicht (9) in einem Arbeitsbereich (10) um den Arbeitspunkt (8) herum eine Dicke unter 1 Millimeter, insbesondere zwischen 0.01 Millimeter und 0.5 Millimeter aufweist.

13. Vorrichtung nach Anspruch 12, **dadurch gekennzeichnet, dass** die Mittel zur Erzeugung der Flüssigkeitsschicht (9) derart ausgebildet sind, dass die Flüssigkeitsschicht im Arbeitsbereich (10) schiessend fliesst.

14. Vorrichtung nach Anspruch 13, **dadurch gekennzeichnet, dass** die Mittel zur Erzeugung der Flüssigkeitsschicht derart ausgebildet sind, dass die Flüssigkeitsschicht ausserhalb des Arbeitsbereichs strömend fliesst und eine zweite Dicke (15) über 1 Millimeter, insbesondere zwischen 1 Millimeter und 5 Millimeter aufweist.

**15.** Vorrichtung nach Anspruch 12 bis 14, **dadurch gekennzeichnet, dass** sie eine zweite Flüssigkeitszuführvorrichtung (32) zur Erzeugung einer trägen Flüssigkeitsschicht der zweiten Dicke umfasst.

**16.** Vorrichtung nach einem der Ansprüche 12 bis 15, **dadurch gekennzeichnet, dass** sie zur Bearbeitung eines Wafers (2), insbesondere zum Schneiden eines Siliziumwafers in eine Vielzahl von Chips (3) ausgebildet ist.

**17.** Vorrichtung nach Anspruch 12 bis 16, **dadurch gekennzeichnet, dass** sie zur Erzeugung der Flüssigkeitsschicht mit einer Flüssigkeit eine erste Flüssigkeitszuführvorrichtung (21) umfasst, welche derart ausgebildet ist, dass die Flüssigkeit in einer Nähe (24) des Arbeitspunktes auf das Werkstück aufbringbar ist.

**18.** Vorrichtung nach Anspruch 17, **dadurch gekennzeichnet, dass** die erste Flüssigkeitszuführrichtung derart ausgebildet ist, dass ein Strahl (20) der Flüssigkeit erzeugbar ist, wobei ein Auftreffwinkel (23) und eine Durchflussmenge des Strahls variierbar sind.

**Claims**

**1.** A method for machining a workpiece (2) by means of laser radiation (6) injected and guided in a liquid jet (7), in which the liquid jet (7) having the laser radiation is directed on to a surface (5) of the workpiece and the workpiece is machined at an operating point (8), **characterized in that** a flowing liquid layer (9) is generated on the surface of the workpiece by means of a liquid, in such a way that said liquid layer has a thickness of less than 1 millimeter, in particular of between 0.01 millimeters and 0.5 millimeters, in an operating region (10) around the operating point (8).

**2.** The method as claimed in claim 1, **characterized in that** the liquid layer (9) is generated in such a way that it has a shooting flow in the operating region (10).

**3.** The method as claimed in claim 1 or 2, **characterized in that** the liquid layer (9) is generated in such a way that it flows in a flowing manner outside the operating region (10) and has a second thickness (15) of above 1 millimeter, in particular of between 1 millimeter and 5 millimeters.

**4.** The method as claimed in one of claims 1 to 3, **characterized in that** the liquid layer (9) is generated on the surface of the workpiece by means of water, in particular by means of deionized water.

**5.** The method as claimed in one of claims 1 to 4, **characterized in that** a wafer (2) is machined, in particular a silicon wafer being cut into a multiplicity of chips (3).

**6.** The method as claimed in one of claims 1 to 5, **characterized in that** the second thickness of the liquid layer is regulated, **in that** substances influencing the surface tension are added to the liquid and/or **in that** a liquid quantity supplied and/or flowing out is varied.

**7.** The method as claimed in one of claims 1 to 6, **characterized in that** the liquid layer is generated **in that** the liquid is applied to the workpiece in the vicinity (24) of the operating point by means of a first liquid supply device (21).

**8.** The method as claimed in claim 7, **characterized in that** a sluggish liquid layer of the second thickness is generated by means of a second liquid supply device (32), the liquid applied in the vicinity of the operating point reducing the thickness of the liquid layer in the operating region to the first thickness.

**9.** The method as claimed in claim 7 or 8, **characterized in that** the liquid is applied to the workpiece in a jet (20) by means of the first liquid supply device (21).

**10.** The method as claimed in claim 9, **characterized in that** the first thickness of the liquid layer and/or a size of the operating region are/is regulated, **in that** an impingement angle and/or a throughflow quantity of the jet (20) are/is varied.

**11.** The method as claimed in claim 10, **characterized in that** the jet is generated with a diameter (22) of between 0.5 millimeters and 4 millimeters, the impingement angle of the jet being varied between 45 degrees and 90 degrees and its throughflow quantity being varied between 1 milliliter per minute and 10 liters per minute, in particular between 20 milliliters per minute and 500 milliliters per minute.

**12.** A device (1) for machining a workpiece (2) by means of laser radiation (6) which can be directed on to a surface (5) of the workpiece, the workpiece being capable of being machined at an operating point (8), and the laser radiation being injected and guided in a liquid jet (7), **characterized in that** the device comprises means (21) for generating a flowing liquid layer (9) on the surface of the workpiece, said means being designed in such a way that the liquid layer (9) has a thickness of less than 1 millimeter, in particular of between 0.01 millimeters and 0.5 millimeters, in an operating region (10) around the operating point (8).

13. The device as claimed in claim 12, **characterized in that** the means for generating the liquid layer (9) are designed in such a way that the liquid layer has a shooting flow in the operating region (10).

14. The device as claimed in claim 13, **characterized in that** the means for generating the liquid layer are designed in such a way that the liquid layer flows in a flowing manner outside the operating region and has a second thickness (15) of above 1 millimeter, in particular of between 1 millimeter and 5 millimeters.

15. The device as claimed in claims 12 to 14, **characterized in that** it comprises a second liquid supply device (32) for generating a sluggish liquid layer of the second thickness.

16. The device as claimed in one of claims 12 to 15, **characterized in that** it is designed for machining a wafer (2), in particular for cutting a silicon wafer into a multiplicity of chips (3).

17. The device as claimed in claims 12 to 16, **characterized in that** it comprises, for generating the liquid layer by means of a liquid, a first liquid supply device (21) which is designed such that the liquid can be applied to the workpiece in the vicinity (24) of the operating point.

18. The device as claimed in claim 17, **characterized in that** the first liquid supply device is designed in such a way that a jet (20) of the liquid can be generated, an impingement angle (23) and a throughflow quantity of the jet being variable.

## Revendications

1. Procédé d'usinage d'une pièce (2) avec un faisceau laser (6) injecté et guidé dans un jet de liquide (7), dans lequel le jet de liquide (7) est orienté avec le faisceau laser sur une surface (5) de la pièce et la pièce est usinée dans un point de travail (8), **caractérisé en ce qu'**une couche de liquide coulante (9) est créée à la surface de la pièce avec un liquide de telle sorte qu'elle présente, dans une région de travail (10) autour du point de travail (8), une épaisseur inférieure à 1 millimètre, en particulier entre 0,01 millimètre et 0,5 millimètre.

2. Procédé selon la revendication 1, **caractérisé en ce que** la couche de liquide (9) est créée en la faisant jaillir dans la région de travail (10).

3. Procédé selon la revendication 1 ou 2, **caractérisé**

**en ce que** la couche de liquide (9) est créée de telle sorte qu'elle s'écoule en dehors de la région de travail (10) et qu'elle présente une deuxième épaisseur (15) supérieure à 1 millimètre, notamment comprise entre 1 millimètre et 5 millimètres.

4. Procédé selon l'une quelconque des revendications 1 à 3, **caractérisé en ce que** la couche de liquide est créée à la surface de la pièce avec de l'eau, en particulier de l'eau désionisée.

5. Procédé selon l'une quelconque des revendications 1 à 4, **caractérisé en ce que** l'on usine une pastille (2), et en particulier on coupe une pastille de silicium pour donner une pluralité de puces (3).

6. Procédé selon l'une quelconque des revendications 1 à 5, **caractérisé en ce que** la deuxième épaisseur de la couche de liquide est régulée en ajoutant au liquide des substances influençant la tension superficielle, et/ou en faisant varier une quantité de liquide acheminée et/ou évacuée.

7. Procédé selon l'une quelconque des revendications 1 à 6, **caractérisé en ce que** la couche de liquide est créée en appliquant le liquide sur la pièce, avec un premier dispositif d'alimentation en liquide (21), à proximité (24) du point de travail.

8. Procédé selon la revendication 7, **caractérisé en ce que** l'on crée avec un deuxième dispositif d'alimentation en liquide (32) une couche de liquide inerte de deuxième épaisseur, le liquide appliqué à proximité du point de travail réduisant l'épaisseur de la couche de liquide dans la région de travail à la première épaisseur.

9. Procédé selon la revendication 7 ou 8, **caractérisé en ce que** le liquide est appliqué avec le premier dispositif d'alimentation en liquide (21) en un jet (20) sur la pièce.

10. Procédé selon la revendication 9, **caractérisé en ce que** la première épaisseur de la couche de liquide et/ou une taille de la région de travail sont régulées en faisant varier un angle d'incidence et/ou une quantité de débit du jet (20).

11. Procédé selon la revendication 10, **caractérisé en ce que** le jet est produit avec un diamètre (22) compris entre 0,5 millimètre et 4 millimètres, l'angle d'incidence du jet étant compris entre 45 degrés et 90 degrés et son débit étant compris entre 1 millilitre par minute et 10 litres par minute, en particulier entre 20 millilitres par minute et 500 millilitres par minute.

12. Dispositif (1) pour l'usinage d'une pièce (2) avec un faisceau laser (6), qui peut être orienté sur une surface (5) de la pièce, la pièce pouvant être usinée en un point de travail (8) et le faisceau laser étant injecté et guidé dans un jet de liquide (7), **caractérisé en ce que** le dispositif présente des moyens (21) pour créer une couche de liquide coulante (9) à la surface de la pièce, ces moyens étant réalisés de telle sorte que la couche de liquide (9) présente, dans une région de travail (10) autour du point de travail (8), une épaisseur inférieure à 1 millimètre, en partie comprise entre 0,01 millimètre et 0,5 millimètre.

13. Dispositif selon la revendication 12, **caractérisé en ce que** les moyens pour créer la couche de liquide (9) sont réalisés de telle sorte que la couche de liquide jaillisse dans la région de travail (10).

14. Dispositif selon la revendication 13, **caractérisé en ce que** les moyens pour créer la couche de liquide sont réalisés de telle sorte que la couche de liquide s'écoule en dehors de la région de travail et présente une deuxième épaisseur (15) supérieure à 1 millimètre, en particulier comprise entre 1 millimètre et 5 millimètres.

15. Dispositif selon l'une quelconque des revendications 12 à 14, **caractérisé en ce qu'**il comprend un deuxième dispositif d'alimentation en liquide (32) pour créer une couche de liquide inerte de deuxième épaisseur.

16. Dispositif selon l'une quelconque des revendications 12 à 15, **caractérisé en ce qu'**il est réalisé pour usiner une pastille (2), en particulier pour couper une pastille de silicium pour donner une pluralité de puces (3).

17. Dispositif selon les revendications 12 à 16, **caractérisé en ce qu'**il comprend un premier dispositif d'alimentation en liquide (21) pour produire la couche de liquide avec un liquide, ce dispositif étant réalisé de telle sorte que le liquide puisse être appliqué à proximité (24) du point de travail sur la pièce.

18. Dispositif selon la revendication 17, **caractérisé en ce que** le premier dispositif d'alimentation en liquide est réalisé de telle sorte qu'un jet (20) de liquide puisse être créé, un angle d'incidence (23) et un débit du jet pouvant être variés.

**Fig. 1**

**Fig. 2**

**Fig. 3**

**EP 1 750 894 B1**

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- WO 9532834 A
- US 3991296 A
- US 2003129814 A1